# EUROPEAN PATENT APPLICATION

(11) **EP 4 712 760 A1**
(43) Date of publication of application: **18.03.2026**
(21) Application number: 25200164.9
(22) Date of filing: 04.09.2025
(51) Int. Cl.: H10W 72/00, H10W 72/20

(54) **SEMICONDUCTOR DEVICE INTERCONNECT STRUCTURE AND METHOD THEREFOR**

(30) Priority: 12.09.2024 CN 202411280705
(71) Applicant: NXP USA, Inc., Austin, TX 78735 (US)
(72) Inventor: Wang, Miao, 5656AG Eindhoven (NL); Uehling, Trent, 5656AG Eindhoven (NL); Lin, Yu Cheng, 5656AG Eindhoven (NL)
(74) Representative: Colaiuda, Antonella

(57) **Abstract**

A method of manufacturing a semiconductor device interconnect structure is provided. The method includes forming a copper pillar on a semiconductor die by way of a plating process. A proximal portion of the copper pillar has a first width dimension, and a distal portion of the copper pillar has a second width dimension. The second width dimension of the distal portion of the copper pillar is configured to be smaller than the first width dimension of the proximal portion of the copper pillar. Sidewalls of the distal portion of the copper pillar are selectively roughened. The roughened sidewalls of the distal portion of the copper pillar are configured to promote solder wetting.

## Description

### Background Field

This disclosure relates generally to semiconductor device packaging, and more specifically, to a semiconductor device interconnect structure and method of forming the same.

### Related Art

Today, there is an increasing trend to include sophisticated semiconductor devices in products and systems that are used every day. These sophisticated semiconductor devices may include features for specific applications which may impact the configuration of the semiconductor device packages, for example. For some features and applications, the configuration of the semiconductor device packages may be susceptible to lower reliability, lower performance, and higher product or system costs. Accordingly, significant challenges exist in accommodating these features and applications while minimizing the impact on semiconductor devices' reliability, performance, and costs.

### Brief Description of the Drawings

The present invention is illustrated by way of example and is not limited by the accompanying figures, in which like references indicate similar elements. Elements in the figures are illustrated for simplicity and clarity and have not necessarily been drawn to scale.
FIG. 1 illustrates, in a simplified cross-sectional view, an example semiconductor device having interconnect structures at a stage of manufacture in accordance with an embodiment.
FIG. 2 illustrates, in a simplified cross-sectional view, the example semiconductor device having interconnect structures at a subsequent stage of manufacture in accordance with an embodiment.
FIG. 3 illustrates, in a simplified cross-sectional view, an alternative example semiconductor device having interconnect structures at a stage of manufacture in accordance with an embodiment.
FIG. 4 illustrates, in a simplified cross-sectional view, the alternative example semiconductor device having interconnect structures at a subsequent stage of manufacture in accordance with an embodiment.
FIG. 5 illustrates, in a simplified flow diagram view, an example method of manufacturing a semiconductor device having interconnect structures in accordance with an embodiment.

### Detailed Description

Generally, there is provided, a semiconductor device having interconnect structures. The semiconductor device includes under bump metallization (UBM) structures connected to die pads formed on a semiconductor die. Copper pillars are formed on seed layer portions over each UBM structure. Each is formed having a proximal portion and a distal portion. The distal portion of each copper pillar is subjected to a surface treatment configured to roughen the sidewall surface of the distal portion. The roughened sidewall surfaces are configured to promote solder wetting. By forming the copper pillars with the roughen the sidewall surface of the distal portions in this manner, reflowed solder forms a slim profile around the distal portion of each copper pillar when the semiconductor die is interconnected with a substrate. The slim solder profile allows the copper pillars to be configured in a fine-pitch arrangement while virtually eliminating the risk of solder bridging. As such, each conductive connection is formed having superior structural integrity and reliability with minimal stress and absence of voiding.

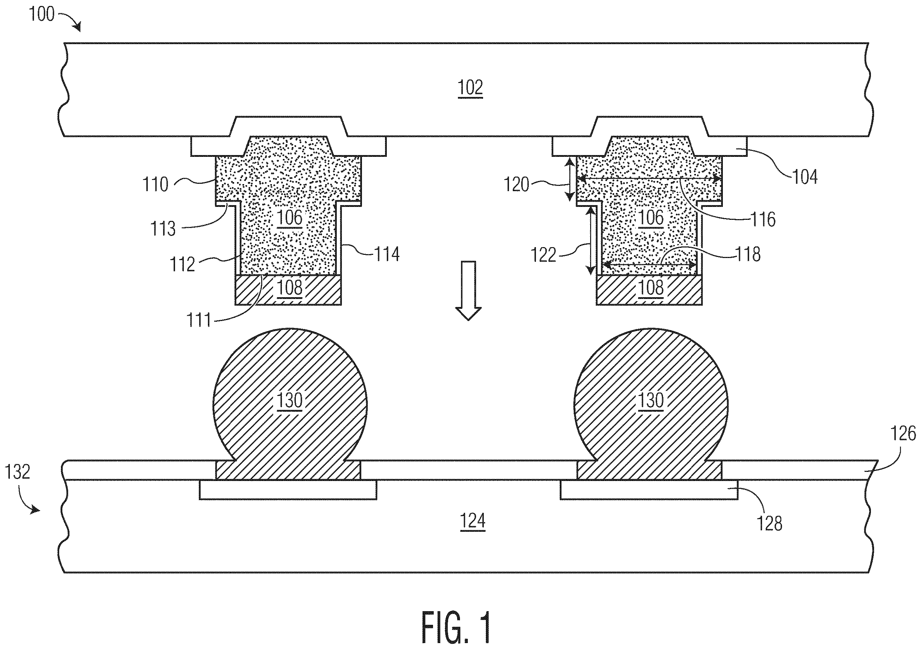

FIG. 1 illustrates, in a simplified cross-sectional view, a portion of an example semiconductor device 100 having interconnect structures at a stage of manufacture in accordance with an embodiment. At this stage, the device 100 includes a semiconductor die 102, UBM structures 104 connected to die pads (not shown) of the semiconductor die, and copper pillars 106 formed over portions of the UBM structures 104. The copper pillars 106 are generally formed on each semiconductor die 102 while in wafer form. In this embodiment, the copper pillars 106 are formed by way of an electrodeposition plating process on the exposed portions of a seed layer (not shown) covering the UBM structures 104. The copper pillars 106 may be characterized as interconnect structures configured to interconnect the semiconductor die with a package substrate or printed circuit board (PCB), for example.

In this embodiment, the copper pillars 106 are configured having a "stepped" or "T" profile shape. A proximal portion 110 of the copper pillars 106 is formed having a first width dimension 116 and a first length dimension 120, and a distal portion 112 of the copper pillars is subsequently formed having a second width dimension 118 and a second length dimension 122. In this embodiment, the width dimension 118 (e.g., diameter) of the distal portion 112 is smaller than the width dimension 116 (e.g., diameter) of the proximal portion 110 of the copper pillars 106. That is, the distal portion 112 is narrower than the proximal portion 110 of each copper pillar 106. For example, the width dimension 118 of the distal portion 112 of the copper pillars 106 may be in a range of 60% to 80% of the width dimension 116 of the proximal portion 110, thus forming the stepped shape.

The length dimension 120 of the proximal portion 110 of each copper pillar 106 is depicted as the vertical distance between the UBM structure 104 and the step at the beginning of the distal portion 112. In this embodiment, the width dimension 116 is a consistent width throughout the length dimension 120 of the proximal portion 110 of each copper pillar. The length dimension 122 of the distal portion 112 of each copper pillar 106 is depicted as the vertical distance between the step at end of the proximal portion 110 and the end or tip of the distal portion 112 of each copper pillar 106. Accordingly, the overall length dimension of each copper pillar 106 is equal to the length dimension 120 of the proximal portion 110 plus the length dimension 122 of the distal portion 112. In this embodiment, the width dimension 118 is a consistent width throughout the length dimension 122 of the distal portion 112 of each copper pillar. In this embodiment, the length dimension 122 of the distal portion 112 is longer than the length dimension 120 of the proximal portion 110 of each copper pillar 106. For example, the length dimension 122 of the distal portion 112 is approximately in a range of 60% to 80% of the overall length dimension of each copper pillar 106. In this embodiment, a distal end surface 111 of the distal portion 112 of each copper pillar is plated with a solder material to form a solder cap 108.

In this embodiment, a roughened surface 114 is selectively formed on the sidewalls of the distal portion 112 and step portion 113 of each copper pillar 106. In some embodiments, the roughened surface 114 may be selectively formed on the sidewalls of the distal portion 112, the step portion 113, and the distal end surface 111 of the distal portion 112 (e.g., before forming solder cap 108) of each copper pillar 106. The roughened surface 114 is configured to promote solder wetting in this embodiment. The roughened surface 114 may be formed by way of an additive (e.g., electrodeposition, sputter) or a subtractive (e.g., etch) surface treatment process. For example, the roughened surface 114 may include micro-structures or nano-structures in the form of dendrites, particles, needles, wires, ribbons, tubes, or the like. In this embodiment, the roughened surface 114 may be characterized as a hydrophilic surface formed by way of the surface treatment process.

The semiconductor die 102 has an active side (e.g., major side having circuitry, bond pads) and the backside (e.g., major side opposite of the active side). As depicted in the cross-sectional view of FIG. 1, the semiconductor die 102 is in an active-side-down orientation, for example. The semiconductor die 102 may be formed from any suitable semiconductor material, such as silicon, germanium, gallium arsenide, gallium nitride, and the like. The semiconductor die 102 may further include digital circuits, analog circuits, RF circuits, power circuits, memory, processor, sensor, the like, and combinations thereof at the active side.

As depicted in FIG. 1, the semiconductor die 102 with copper pillars 106 is positioned over a substrate structure 132 (e.g., package substrate, PCB). The substrate structure includes a non-conductive substrate 124, a solder mask layer 126 formed over the substrate 124, conductive substrate pads 128 exposed through the solder mask, and interconnecting traces (not shown) embedded in the substrate. Solder balls 130 are affixed to the substrate pads 128 and configured for interconnection with the copper pillars 106 during a reflow process at a subsequent stage of manufacture. The term "conductive," as used herein, generally refers to electrical conductivity unless otherwise described.

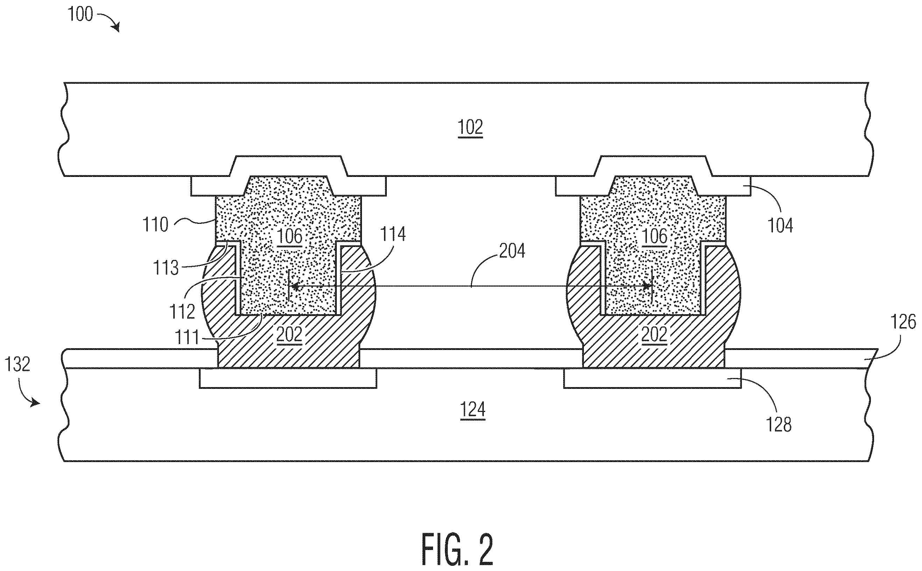

FIG. 2 illustrates, in a simplified cross-sectional view, a portion of an example semiconductor device 100 having interconnect structures at a subsequent stage of manufacture in accordance with an embodiment. At this state, the device 100 includes the semiconductor die 102 with copper pillars 106 joined with the substrate structure 132. In this embodiment, the copper pillars 106 are interconnected with the substrate pads 128 of substrate structure 132 by way of reflowed solder 202. For example, the copper pillars 106 are in contact with the solder balls 130 (FIG. 1) during a reflow process allowing molten solder (of solder balls 130) to wet along the roughened surface 114 thus forming conductive connections between the semiconductor die 102 and the substrate structure 132. By forming the conductive connections in this manner, the reflowed solder 202 forms a slim profile (e.g., minimal solder bulging) around the distal portion 112 of each copper pillar 106. As such, each conductive connection is formed have a superior structural integrity with minimal stress and absence of voiding. In this embodiment, reflowed solder 202 does not wet along sidewalls of the proximal portion 110 of each copper pillar 106. That is, the sidewalls of the proximal portion 110 of each copper pillar 106 remains free of solder after the reflow process.

In this embodiment, the copper pillars 106 are arranged in a fine-pitch arrangement having a centerline-to-centerline dimension 204 less than or equal to 150 microns. By forming the conductive connections between the semiconductor die 102 and the substrate structure 132 with the slim profile reflowed solder 202 as depicted in FIG. 2, copper pillars 106 in a fine-pitch arrangement can be formed virtually eliminating risk of solder bridging.

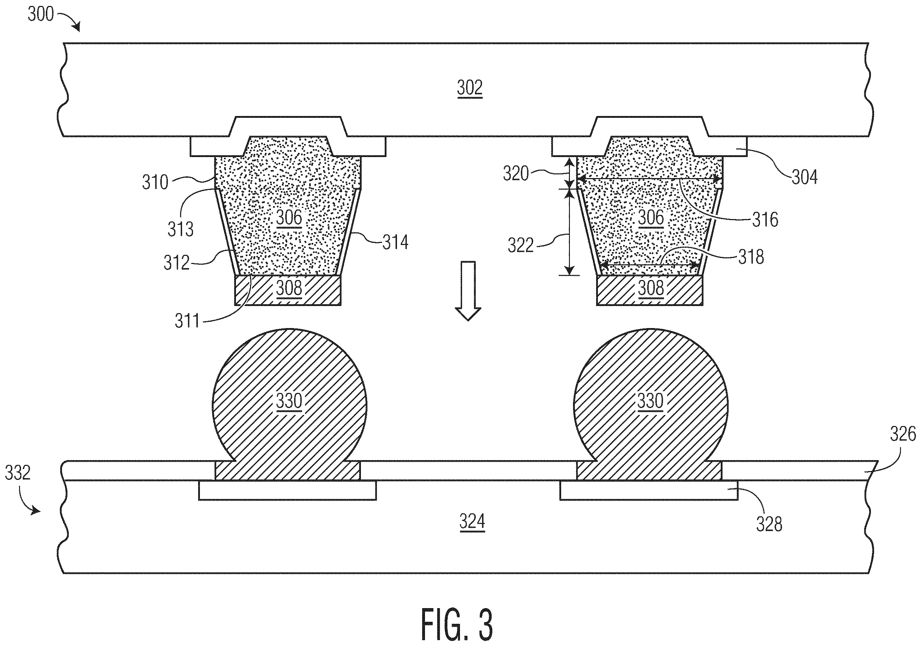

FIG. 3 illustrates, in a simplified cross-sectional view, a portion of an alternative example semiconductor device 300 having interconnect structures at a stage of manufacture in accordance with an embodiment. At this stage, the device 300 includes a semiconductor die 302, UBM structures 304 connected to die pads (not shown) of the semiconductor die, and copper pillars 306 formed over portions of the UBM structures 304. In this embodiment, the copper pillars 306 are formed by way of an electrodeposition plating process on the exposed portions of a seed layer (not shown) covering the UBM structures 304. The copper pillars 306 may be characterized as interconnect structures configured to interconnect the semiconductor die with a package substrate or PCB, for example.

In this embodiment, the copper pillars 306 are configured having a tapered (e.g., conical) profile shape. A proximal portion 310 of the copper pillars 306 is formed having a first width dimension 316 and a first length dimension 320, and a distal portion 312 of the copper pillars is subsequently formed having a second (tapered) width dimension 318 and a second length dimension 322. In this embodiment, the width dimension 318 (e.g., diameter) of the distal portion 312 is smaller than the width dimension 316 (e.g., diameter) of the proximal portion 310 of the copper pillars 306. As depicted in FIG. 3, the width of the distal portion 312 of the copper pillars 306 begins (adjacent to the proximal portion 310) with a width slightly less than the width dimension 316 of the proximal portion 310 and gradually decreases to the end or tip of the distal portion 112 of each copper pillar 106, thus forming the tapered shape. For discussion purposes, the width dimension 318 may be generally characterized as the width of the distal portion 112 of each copper pillar 106 at the distal end of the distal portion 312. In this embodiment, the width dimension 318 (at the distal end of the distal portion 312) may be in a range of 60% to 80% of the width dimension 316 of the proximal portion 310. In this embodiment, the taper of the distal portion 112 of each copper pillar 106 is linear. In other embodiments, the taper of the distal portion may be non-linear or micro-stepped, for example.

The length dimension 320 of the proximal portion 310 of each copper pillar 306 is depicted as the vertical distance between the UBM structure 304 and the beginning of the distal portion 312. In this embodiment, the width dimension 316 is a consistent width throughout the length dimension 320 of the proximal portion 310 of each copper pillar. The length dimension 322 of the distal portion 312 of each copper pillar 306 is depicted as the vertical distance between the end of the proximal portion 310 and the end or tip of the distal portion 312 of each copper pillar 306. Accordingly, the overall length dimension of each copper pillar 306 is equal to the length dimension 320 of the proximal portion 310 plus the length dimension 322 of the distal portion 312. In this embodiment, the width dimension 318 is a tapered width (e.g., decreasing) throughout the length dimension 322 of the distal portion 312 of each copper pillar. In this embodiment, the length dimension 322 of the distal portion 312 is longer than the length dimension 320 of the proximal portion 310 of each copper pillar 306. For example, the length dimension 322 of the distal portion 312 is approximately in a range of 60% to 80% of the overall length dimension of each copper pillar 306. In this embodiment, a distal end surface 311 of the distal portion 312 of each copper pillar is plated with a solder material to form a solder cap 308.

In this embodiment, a roughened surface 314 is selectively formed on the sidewalls of the distal portion 312 each copper pillar 306. In some embodiments, the roughened surface 314 may be selectively formed on the sidewalls of the distal portion 312 and the distal end surface 311 of the distal portion 312 (e.g., before forming solder cap 308) of each copper pillar 306. The roughened surface 314 is configured to promote solder wetting in this embodiment. The roughened surface 314 may be formed by way of an additive (e.g., electrodeposition, sputter) or a subtractive (e.g., etch) surface treatment process. For example, the roughened surface 314 may include micro-structures or nano-structures in the form of dendrites, particles, needles, wires, ribbons, tubes, or the like. In this embodiment, the roughened surface 314 may be characterized as a hydrophilic surface formed by way of the surface treatment process. That is, the sidewalls of the proximal portion 310 of each copper pillar 306 remains free of solder after the reflow process.

The semiconductor die 302 has an active side (e.g., major side having circuitry, bond pads) and the backside (e.g., major side opposite of the active side). As depicted in the cross-sectional view of FIG. 3, the semiconductor die 302 is in an active-side-down orientation, for example. The semiconductor die 302 may be formed from any suitable semiconductor material, such as silicon, germanium, gallium arsenide, gallium nitride, and the like. The semiconductor die 302 may further include digital circuits, analog circuits, RF circuits, power circuits, memory, processor, sensor, the like, and combinations thereof at the active side.

As depicted in FIG. 3, the semiconductor die 302 with copper pillars 306 is positioned over a substrate structure 332 (e.g., package substrate, PCB). The substrate structure includes a non-conductive substrate 324, a solder mask layer 326 formed over the substrate 324, conductive substrate pads 328 exposed through the solder mask, and interconnecting traces (not shown) embedded in the substrate. Solder balls 330 are affixed to the substrate pads 328 and configured for interconnection with the copper pillars 306 during a reflow process at a subsequent stage of manufacture.

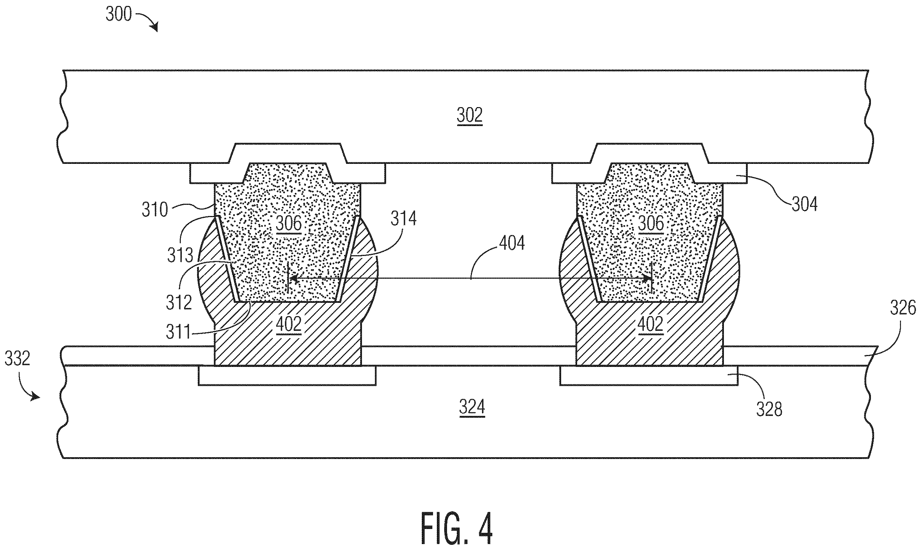

FIG. 4 illustrates, in a simplified cross-sectional view, a portion of an example semiconductor device 300 having interconnect structures at a subsequent stage of manufacture in accordance with an embodiment. At this state, the device 300 includes the semiconductor die 302 with copper pillars 306 joined with the substrate structure 332. In this embodiment, the copper pillars 306 are interconnected with the substrate pads 328 of substrate structure 332 by way of reflowed solder 402. For example, the copper pillars 306 are in contact with the solder balls 330 (FIG. 3) during a reflow process allowing molten solder (of solder balls 330) to wet along the roughened surface 314 thus forming conductive connections between the semiconductor die 302 and the substrate structure 332. By forming the conductive connections in this manner, the reflowed solder 402 forms a slim profile (e.g., minimal solder bulging) around the distal portion 312 of each copper pillar 306. As such, each conductive connection is formed have a superior structural integrity with minimal stress and absence of voiding. In this embodiment, reflowed solder 402 does not wet along sidewalls of the proximal portion 310 of each copper pillar 306.

In this embodiment, the copper pillars 306 are arranged in a fine-pitch arrangement having a centerline-to-centerline dimension 404 less than or equal to 150 microns. By forming the conductive connections between the semiconductor die 302 and the substrate structure 332 with the slim profile reflowed solder 402 as depicted in FIG. 4, copper pillars 106 in a fine-pitch arrangement can be formed virtually eliminating risk of solder bridging.

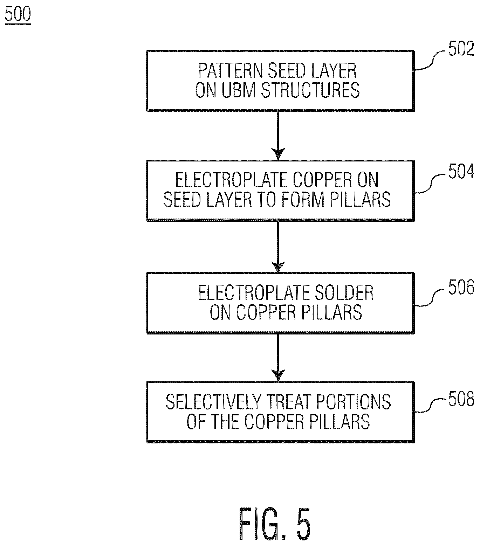

FIG. 5 illustrates, in a simplified flow diagram view, an example method 500 of manufacturing example interconnect structures in accordance with an embodiment. The method 500 in this embodiment is consistent with the example interconnect structures 106 depicted in FIGs. 1 and 2 and the alternative example interconnect structures 306 depicted in FIGs. 3 and 4.

At step 502, pattern seed layer on UBM structure. In this embodiment, the semiconductor die includes die pads interconnected to respective UBM structures. A seed layer is formed over the semiconductor die (at the wafer level) and patterned such that a portion of the seed layer is exposed over the UBM structures. The seed layer may be formed as a single sputtered seed layer (e.g., copper) or a combination layer including a sputtered barrier layer (e.g., tantalum, tantalum nitride, titanium) followed by a sputtered seed layer (e.g., copper), for example. The seed layer may be patterned using known photolithography and etch processes.

At step 504, electroplate copper on seed layer to form pillars. In this embodiment, copper pillars are formed over the UBM structures by way of an electroplating process. After patterning the seed layer formed over the semiconductor die, copper pillars are electroplated on the exposed portion of the seed layer over the UBM structures. Each of the copper pillars is configured having a proximal portion and a distal portion. In this embodiment, the proximal portion is wider than the distal portion. For example, a stepped copper pillar shape may include the width dimension of the distal portion formed having a uniform diameter smaller than the proximal portion. In another example, a tapered copper pillar shape may include the width dimension of the distal portion formed having a tapered diameter smaller than the proximal portion. The electrodeposition to form the stepped or tapered shape of the copper pillars may utilize known single step or multi-step photolithography processes.

At step 506, electroplate solder on copper pillars. In this embodiment, a solder material is plated on the end or tip of the copper pillars. After forming the copper pillars, the distal end surface of the distal portion of each copper pillar is plated with the solder material to form a solder cap. The solder material may include a solder alloy material such as tin-silver, for example.

At step 508, selectively treat portions of the copper pillars. In this embodiment, a roughened surface is selectively formed on the sidewalls of the distal portion each copper pillar. After forming the copper pillars, the distal portions of the copper pillars are subjected to a surface treatment process to roughen the sidewalls of the distal portions, for example. The roughened surface may be formed by way of an additive (e.g., electrodeposition, sputter) or a subtractive (e.g., etch) surface treatment process. For example, the roughened surface may include micro-structures or nano-structures in the form of dendrites, particles, needles, wires, ribbons, tubes, or the like. The roughened surface is configured to promote solder wetting in this embodiment.

Generally, there is provided, a method including forming a first copper pillar on a semiconductor die by way of a plating process, a proximal portion of the first copper pillar having a first width dimension and a distal portion of the first copper pillar having a second width dimension, the second width dimension smaller than the first width dimension; and selectively roughening sidewalls of the distal portion of the first copper pillar, the roughened sidewalls of the distal portion of the first copper pillar configured to promote solder wetting. The first copper pillar may be formed on an under bump metallization (UBM) structure of the semiconductor die. The method may further include plating a distal end surface of the distal portion of the first copper pillar with a solder material. The proximal portion of the first copper pillar has a first length dimension and the distal portion of the first copper pillar has a second length dimension, the second length dimension may be longer than the first length dimension. The method second length dimension may be in a range of 60% to 80% of an overall length dimension of the first copper pillar, the overall length dimension being equal to the first length dimension plus the second length dimension. The second width dimension may be a consistent width throughout the second length dimension of the distal portion of the first copper pillar. The distal portion of the first copper pillar may be formed in a tapered configuration having a first tapered width dimension adjacent to the proximal portion of the first copper pillar and a second tapered width dimension at a distal end of the distal portion of the first copper pillar, the first tapered width dimension approximately equal to the first width dimension of the proximal portion and the second tapered width dimension approximately equal to the second width dimension of the distal portion of the first copper pillar. The method may further include forming a second copper pillar on the semiconductor die by way of the plating process, the second copper pillar proximate to the first copper pillar in a fine-pitch arrangement. The method may further include interconnecting the semiconductor die with a printed circuit board (PCB) by way of the first copper pillar during a reflow process, the reflow process causing solder to wet to the roughened sidewalls of the distal portion of the first copper pillar.

In another embodiment, there is provided, a method including forming a first copper pillar and a second copper pillar on a semiconductor die by way of a plating process, each copper pillar includes a proximal portion having a first width dimension and a distal portion having a second width dimension, the second width dimension smaller than the first width dimension; and selectively roughening sidewalls of the distal portion of each copper pillar, the roughened sidewalls of the distal portion of the copper pillars configured to promote solder wetting. The second copper pillar may be proximate to the first copper pillar in a fine-pitch arrangement having centerline-to-centerline pitch less than or equal to 150 microns. The method may further include plating a distal end surface of the distal portion of each copper pillar with a solder material. The proximal portion of each copper pillar has a first length dimension and the distal portion of each copper pillar has a second length dimension, the second length dimension may be longer than the first length dimension. The second width dimension may be a consistent width throughout the second length dimension of the distal portion of each copper pillar. The selectively roughening the sidewalls of the distal portion of each copper pillar may include forming nano-structures on the sidewalls of the distal portion of each copper pillar.

In yet another embodiment, there is provided, a semiconductor device including a semiconductor die; a first copper pillar formed on the semiconductor die, a proximal portion of the first copper pillar having a first width dimension and a distal portion of the first copper pillar having a second width dimension, the second width dimension smaller than the first width dimension; and a roughened surface formed on sidewalls of the distal portion of the first copper pillar, the roughened surface formed of the sidewalls of the distal portion of the first copper pillar configured to promote solder wetting. The semiconductor device may further include a solder cap formed at a distal end of the distal portion of the first copper pillar. The proximal portion of the first copper pillar has a first length dimension and the distal portion of the first copper pillar has a second length dimension, the second length dimension may be longer than the first length dimension. The roughened surface may include nano-structures in the form of dendrites, particles, needles, wires, ribbons, or tubes. The semiconductor device may further include a second copper pillar formed on the semiconductor die, the second copper pillar proximate to the first copper pillar in a fine-pitch arrangement having centerline-to-centerline pitch less than or equal to 150 microns.

By now, it should be appreciated that there has been provided, a semiconductor device having interconnect structures. The semiconductor device includes UBM structures connected to die pads formed on a semiconductor die. Copper pillars are formed on seed layer portions over each UBM structure. Each is formed having a proximal portion and a distal portion. The distal portion of each copper pillar is subjected to a surface treatment configured to roughen the sidewall surface of the distal portion. The roughened sidewall surfaces are configured to promote solder wetting. By forming the copper pillars with the roughen the sidewall surface of the distal portions in this manner, reflowed solder forms a slim profile around the distal portion of each copper pillar when the semiconductor die is interconnected with a substrate. The slim solder profile allows the copper pillars to be configured in a fine-pitch arrangement while virtually eliminating the risk of solder bridging. As such, each conductive connection is formed having superior structural integrity and reliability with minimal stress and absence of voiding.

The terms "front," "back," "top," "bottom," "over," "under" and the like in the description and in the claims, if any, are used for descriptive purposes and not necessarily for describing permanent relative positions. It is understood that the terms so used are interchangeable under appropriate circumstances such that the embodiments of the invention described herein are, for example, capable of operation in other orientations than those illustrated or otherwise described herein.

Although the invention is described herein with reference to specific embodiments, various modifications and changes can be made without departing from the scope of the present invention as set forth in the claims below. Accordingly, the specification and figures are to be regarded in an illustrative rather than a restrictive sense, and all such modifications are intended to be included within the scope of the present invention. Any benefits, advantages, or solutions to problems that are described herein with regard to specific embodiments are not intended to be construed as a critical, required, or essential feature or element of any or all the claims.

Furthermore, the terms "a" or "an," as used herein, are defined as one or more than one. Also, the use of introductory phrases such as "at least one" and "one or more" in the claims should not be construed to imply that the introduction of another claim element by the indefinite articles "a" or "an" limits any particular claim containing such introduced claim element to inventions containing only one such element, even when the same claim includes the introductory phrases "one or more" or "at least one" and indefinite articles such as "a" or "an." The same holds true for the use of definite articles.

Unless stated otherwise, terms such as "first" and "second" are used to arbitrarily distinguish between the elements such terms describe. Thus, these terms are not necessarily intended to indicate temporal or other prioritization of such elements.

## Claims

1. A method comprising:
forming a first copper pillar on a semiconductor die by way of a plating process, a proximal portion of the first copper pillar having a first width dimension and a distal portion of the first copper pillar having a second width dimension, the second width dimension smaller than the first width dimension; and
selectively roughening sidewalls of the distal portion of the first copper pillar, the roughened sidewalls of the distal portion of the first copper pillar configured to promote solder wetting.

2. The method of claim 1, wherein the first copper pillar is formed on an under bump metallization (UBM) structure of the semiconductor die.

3. The method according to any preceding claim, further comprising plating a distal end surface of the distal portion of the first copper pillar with a solder material.

4. The method according to any preceding claim, wherein the proximal portion of the first copper pillar has a first length dimension and the distal portion of the first copper pillar has a second length dimension, the second length dimension longer than the first length dimension.

5. The method of claim 4, wherein the second length dimension is in a range of 60% to 80% of an overall length dimension of the first copper pillar, the overall length dimension being equal to the first length dimension plus the second length dimension.

6. The method of claim 4, wherein the second width dimension is a consistent width throughout the second length dimension of the distal portion of the first copper pillar.

7. The method according to any preceding claim, wherein the distal portion of the first copper pillar is formed in a tapered configuration having a first tapered width dimension adjacent to the proximal portion of the first copper pillar and a second tapered width dimension at a distal end of the distal portion of the first copper pillar, the first tapered width dimension approximately equal to the first width dimension of the proximal portion and the second tapered width dimension approximately equal to the second width dimension of the distal portion of the first copper pillar.

8. The method according to any preceding claim, further comprising forming a second copper pillar on the semiconductor die by way of the plating process, the second copper pillar proximate to the first copper pillar in a fine-pitch arrangement.

9. The method according to any preceding claim, further comprising interconnecting the semiconductor die with a printed circuit board (PCB) by way of the first copper pillar during a reflow process, the reflow process causing solder to wet to the roughened sidewalls of the distal portion of the first copper pillar.

10. A semiconductor device comprising:
a semiconductor die;
a first copper pillar formed on the semiconductor die, a proximal portion of the first copper pillar having a first width dimension and a distal portion of the first copper pillar having a second width dimension, the second width dimension smaller than the first width dimension; and
a roughened surface formed on sidewalls of the distal portion of the first copper pillar, the roughened surface formed of the sidewalls of the distal portion of the first copper pillar configured to promote solder wetting.

11. The semiconductor device of claim 10, further comprising a solder cap formed at a distal end of the distal portion of the first copper pillar.

12. The semiconductor device of claim 10 or claim 11, wherein the proximal portion of the first copper pillar has a first length dimension and the distal portion of the first copper pillar has a second length dimension, the second length dimension longer than the first length dimension.

13. The semiconductor device according to claim 10 to claim 12, wherein the roughened surface includes nano-structures in the form of dendrites, particles, needles, wires, ribbons, or tubes.

14. The semiconductor device according to claim 10 to claim 13, further comprising a second copper pillar formed on the semiconductor die, the second copper pillar proximate to the first copper pillar in a fine-pitch arrangement having centerline-to-centerline pitch less than or equal to 150 microns.
